# EUROPEAN PATENT APPLICATION

(11) **EP 1 783 837 A1**
(43) Date of publication of application: **09.05.2007**
(21) Application number: 04735408.9
(22) Date of filing: 28.05.2004
(51) Int. Cl.: H01L 31/042, H01L 31/18

(54) **SOLAR BATTERY CELL MANUFACTURING APPARATUS**

(71) Applicant: Mech Corporation, Yamashina-ku Kyoto-shi, Kyoto 607-8307 (JP)
(72) Inventor: KIRIYAMA, Ryuichi, c/o MECH CORPORATION, Kyoto-shi,Kyo to 607-8307 (JP)
(74) Representative: Feldmeier, Jürgen
(86) International application number: PCT/JP2004/007806
(87) International publication number: WO 2005/117140

(57) **Abstract**

A solar cell fabrication apparatus includes a lower belt carrying a solar cell main body (20) and tab lead (21) to convey the same, and an upper belt (5a, 5b) pressing the same. A phosphor bronze plate (11) is provided to apply an urging force against upper belts (5a, 5b) towards the lower belt. A plurality of lower heater blocks (7) and upper heater blocks (8) to heat a solar cell main body (20) and tab lead (21) from below and above, respectively, and a plurality of lower cooling blocks and upper cooling blocks to cool the same are provided. Lower heater blocks (7a-7e) and upper heater blocks (8a-8d) are surrounded by a heat insulator along the transportation direction.

## Description

### Technical Field

The present invention relates to solar cell fabrication apparatuses, particularly a solar cell fabrication apparatus for soldering a tab lead to a solar cell main body.

### Background Art

Recently, attention is focused on solar cells as clean energy. In general, solar cells are used in the form of a solar cell having a tab lead attached to the main body thereof. To fabricate such solar cells, a solar cell fabrication apparatus to solder a tab lead to the main body of the solar cell is employed.

With regards to a conventional solar cell fabrication apparatus, a tab lead soldering apparatus disclosed in Japanese Patent Laying-Open No. 2000-22188 will be described hereinafter.

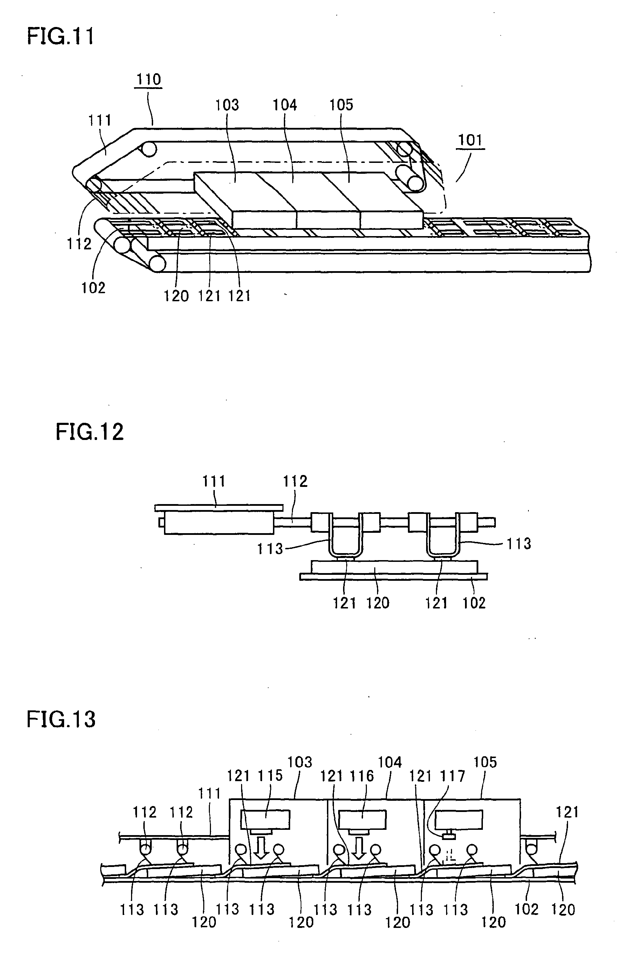

Referring to Fig. 11, a conventional tab lead soldering apparatus 101 includes a conveyer 102 to convey a solar cell main body 120 and a tab lead 121.

Above conveyer 102 is provided a holding mechanism 110 to convey solar cell main body 120 and tab lead 121 while holding solar main body 120 with its electrode portion abutting against tab lead 121.

Holding mechanism 110 is provided with an endless belt 111 wound around a predetermined roller. Endless belt 111 is driven to move in the same direction and same speed as conveyer 102 while facing the top surface of conveyer 102.

A plurality of pressing rods 112 arranged at a predetermined interval are provided around endless belt 111. As shown in Fig. 12, endless belt 111 is arranged in parallel with conveyer 102 such that the leading end of each pressing rod 112 is located above conveyer 102. A holding member 113 to urge tab lead 121 against solar cell main body 120 is attached at the leading end of each pressing rod 112.

Further, as shown in Fig. 11, a sub-heater 103, a main heater 104, and a pusher 105 are provided above conveyer 102. As shown in Fig. 13, a lamp heater 115 is provided at sub-heater 103.

A lamp heater 116 is provided for main heater 104. Pressure 105 is provided with a pusher rod 117 to press tab lead 121 against solar cell main body 120.

The operation of tab lead soldering apparatus set forth above will be described hereinafter. At the beginning, a tab lead and a solar cell main body are placed on conveyer 102 in a positioned state therebetween.

Tab lead 121 and solar cell main body 120 placed on conveyer 102 are sequentially moved under sub-heater 103, main heater 104 and pusher 105 by the drive of conveyer 102, as shown in Fig. 13.

At sub-heater 103, the solder applied on the surface of tab lead 121 is preheated by lamp heater 115. At main heater 104, the solder applied on the surface of tab lead 121 melts by lamp heater 116.

At pusher 105, tab lead 121 is urged against solar cell main body 120 by pusher rod 117, whereby solar cell main body 120 is electrically connected to tab lead 121.

Such a solar cell having tab lead 121 soldered to main body 120 is picked up from conveyer 102 to be sent to the next step. A conventional tab lead soldering apparatus is configured and operates as set forth above.

The conventional tab lead soldering apparatus set forth above had the following problems.

As shown in Fig. 12 or 13, tab lead 121 is urged against solar cell main body 120 by a pressing rod 112 that moves in the same direction and same speed as conveyer 102.

The flux to prevent oxidation during soldering is readily attached to pressing rod 112. There is a possibility of the flux gradually accumulating on pressing rod 112 over the operating time of the tab lead soldering apparatus.

Such accumulation of flux on pressing rod 112 facilitates attachment of the solder of tab lead 121 to the accumulated flux. If solder is attached to the flux, the solder attached to the flux will be pulled up when pressing rod 112 is detached from tab lead 121, resulting in a protruding solder.

If there is such a protruding solder at the surface of the tab lead, the leading end of the protruding solder may form contact with the glass substrate to damage the solar cell main body at the subsequent step of sealing the solar cell main body between a glass substrate and a back film with predetermined resin. As a result, there was the possibility of degradation in the solar cell yield.

When such a protruding solder penetrates the resin to form contact with the glass substrate, oxygen will readily enter to cause degradation in the quality of the solar cell such as reducing the life time thereof.

The solder attached to the flux may not be separated from pressing rod 112 when pressing rod 112 is detached from tab lead 121, leading to the possibility of tab lead 121 being pulled up together with the solder. In this case, solar cell main body 120 is readily damaged, leading to the possibility of degradation in the solar cell yield.

There is also the possibility of solar cell main body 120 being distorted due to the local pushing of tab lead 121 against solar cell main body 120 by pressing rod 112. Therefore, there was the possibility of degradation in the solar cell yield.

Lamp heaters 115 and 116 are employed to preheat and also melt the solder applied on the surface of tab lead 121.

Heating by means of lamp heater 115 and 116 is effected by focusing the light of lamp heaters 115 and 116 onto tab lead 121. Therefore, tab lead 121 and the neighborhood thereof will be locally heated.

This local heating of the solar cell main body about the region where tab lead 121 is located facilitates heat strain in solar cell main body 120. Therefore, there was the possibility of degradation in the solar cell yield.

### Disclosure of the Invention

The present invention is directed to solving the problems set forth above. An object is to provide a solar cell fabrication apparatus aiming to improve the yield of solar cells.

According to an aspect of the present invention, a solar cell fabrication apparatus to solder a tab lead to a solar cell main body includes a conveyor unit, a lower heating unit, an upper heating unit, and a furnace unit. The conveyor unit carries a solar cell main body and a tab lead to convey the solar cell main body and tab lead in one direction. The lower heating unit is provided below the conveyor unit to heat the solar cell main body and tab lead from below. The upper heating unit is provided above the conveyor unit, opposite to the lower heating unit, to heat the solar cell main body and tab lead from above. The furnace unit is arranged to surround the conveyor unit, the lower heating unit, and the upper heating unit along in one direction.

According to such a configuration in which the furnace unit is arranged to surround the lower heating unit and upper heating unit along in one direction, the generation of heat strain is reduced by virtue of the entire heating at the solar cell main body, as compared to the case where the solar cell main body is locally heated. As a result, the solar cell yield can be improved.

A plurality of each of the lower heating units and upper heating units are arranged along in one direction.

By adjusting the setting temperature of each of the plurality of upper and lower heating units, the desired temperature profile suitable for heating and melting solder to connect the tab lead to the solar cell main body can be obtained. As a result, the generation of heat strain at the solar cell main body can be reduced to further improve the solar cell yield.

Preferably, an inert gas supply unit to supply inert gas into the furnace unit is provided.

Accordingly, formation of an oxide film on the surface of the solder is suppressed to improve the wettability of the solder. As a result, the connection between the tab lead and solar cell main body can be ensured.

According to another aspect of the present invention, a solar cell fabrication apparatus to solder a tab lead to a solar cell main body includes a conveyor unit, a lower heating unit, a belt unit, an elastic member, and an upper heating unit. The conveyor unit carries a solar cell main body and a tab lead to convey the solar cell main body and tab lead in one direction. The lower heating unit is provided below the conveyor unit to heat the solar cell main body and tab lead from below. The belt unit is provided above the conveyor unit and presses the solar cell main body and the tab lead arranged at a predetermined position with respect to the solar cell main body towards the conveyor unit in synchronization with the motion of the conveyor unit. The elastic member is provided above the belt unit to apply an urging force against the belt unit in the direction towards the conveyor unit. The upper heating unit is provided above the conveyor unit, opposite to the lower heating unit, to heat the solar cell main body and the tab lead from above.

By the configuration set forth above, the entirety of the solar cell main body and the tab lead will be pressed appropriately by the weight of the belt unit and the elastic force of the elastic member. Accordingly, generation of distortion at the solar cell main body can be suppressed, as compared to the case where the tab lead is locally urged against the solar cell main body. As a result, the solar cell yield can be improved.

The elastic member is preferably arranged between the belt unit and the upper heating unit.

Accordingly, abrasion of the upper heating unit in association with the drive of the belt unit can be prevented.

Further, a heat conductive plate is arranged between the conveyor unit and the lower heating unit.

This prevents abrasion of the lower heating unit in association with the drive of the conveyor unit.

Further preferably, a predetermined protection film to prevent flux attachment is formed on the face of the belt unit at the side forming contact with a solar cell main body and tab lead.

Accordingly, damage and the like at the solar cell main body caused by the attachment of solder due to accumulation of flux at the surface of the belt unit can be prevented. As a result, the solar cell yield can be improved.

Further preferably, a cleaning mechanism is provided for cleaning the face of the belt unit at the side forming contact with the solar cell main body and tab lead.

In this case, flux can be removed, even if it is attached to the surface of the belt unit, at a relatively initial stage by the cleaning roller mechanism. As a result, gradual accumulation of flux can be prevented. Further, the maintenance property can be improved.

According to a further aspect of the present invention, a solar cell fabrication apparatus to solder a tab lead to a solar cell main body includes a conveyor unit, a heating unit, a plurality of lower cooling units, and a plurality of upper cooling units. The conveyor unit carries a solar cell main body and tab lead to convey the solar cell main body and tab lead in one direction. The heating unit heats the solar cell main body and tab lead conveyed by the conveyor unit. The plurality of lower cooling units are provided below the conveyor unit to cool the solar cell main body and tab lead heated by the heating unit from below. The plurality of upper cooling units are provided above the conveyor unit, opposite to the lower cooling unit, to cool the solar cell main body and tab lead from above.

By adjusting the temperature of each of the upper cooling units and lower cooling units according to the configuration set forth above, the desired temperature profile suitable for solidifying the melted solder to connect the tab lead to the solar cell main body is obtained. As a result, generation of distortion in association with cooling the solar cell main body is reduced to allow improvement of the solar cell yield.

To effect temperature adjustment, a coolant supply unit to supply coolant to each of the lower and upper cooling units is preferably provided.

Accordingly, the temperature adjustment of each of the upper and lower cooling units can be conducted relatively easily by adjusting the amount of the coolant.

### Brief Description of the Drawings

Fig. 1 is a perspective view of an entire solar cell fabrication apparatus according to an embodiment of the present invention.
Fig. 2 is a first partial enlarged sectional view of the solar cell fabrication apparatus of Fig. 1 taken along the transportation direction according to the same embodiment.
Fig. 3 is a sectional view taken along line III-III of Fig. 2 in the same embodiment.
Fig. 4 is a second partial enlarged sectional view of the solar cell fabrication apparatus of Fig. 1 taken along a transportation direction thereof in the same embodiment.
Fig. 5 is a perspective view of a solar cell main body and tab lead to describe a fabrication method of a solar cell according to the solar cell fabrication apparatus of Fig. 1 in the same embodiment.

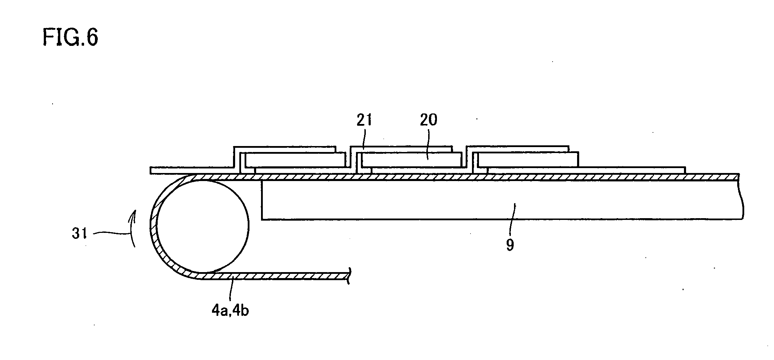

Fig. 6 is a partial enlarged sectional view of a state of a solar cell main body and tab lead mounted on a lower belt in the same embodiment.
Fig. 7 is a partial enlarged sectional view of a state subsequent to the state of Fig. 6 according to the same embodiment.
Fig. 8 is a sectional view taken along line VIII-VIII of Fig. 7 according to the same embodiment.
Fig. 9 is a partial enlarged sectional view of a state subsequent to the state of Fig. 7 according to the same embodiment.
Fig. 10 is a perspective view of a solar cell having a tab lead soldered to the main body, taken out subsequent to the state of Fig. 9 according to the same embodiment.
Fig. 11 is a partial perspective view of a conventional solar cell fabrication apparatus.
Fig. 12 is a partial enlarged sectional view of the solar cell fabrication apparatus of Fig. 11 taken along a transportation direction thereof.
Fig. 13 is a partial enlarged sectional view of the solar cell fabrication apparatus of Fig. 11 taken in a direction orthogonal to the transportation direction thereof.

### Best Modes for Carrying Out the Invention

A solar cell fabrication apparatus according to an embodiment of the present invention will be described hereinafter. In the solar cell fabrication apparatus, solar cells are fabricated by soldering a tab lead to the main body of a solar cell.

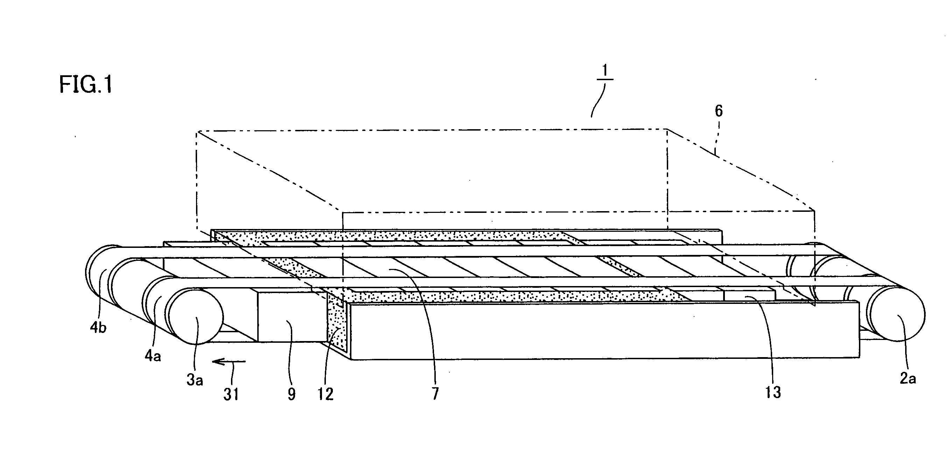

As shown in Fig. 1, a solar cell fabrication apparatus 1 includes a pair of lower belts 4a and 4b carrying a solar cell main body 20 and a tab lead 21 to convey the same in one direction. Lower belts 4a and 4b are formed of, for example, steel.

The pair of lower belts 4a and 4b are wound around a drive roller 2a and a driven roller 3 a to be driven in the direction indicated by arrow 31 by drive roller 2a.

At the side where driven roller 3 a is arranged, a stage unit 9 for receiving solar cell main body 20 and tab lead 21 is provided. Solar cell main body 20 and tab lead 21 are first mounted on lower belts 4a and 4b located above stage unit 9.

During the zone where stage unit 9 is located, solar cell main body 20 and tab lead 21 mounted on lower belts 4a and 4b are conveyed in a state secured to lower belts 4a and 4b by adsorption.

For the purpose of securing solar cell main body 20 and tab lead 21 to lower belts 4a and 4b by adsorption, a plurality of openings (not shown) are formed along the transportation direction at lower belts 4a and 4b. A groove (not shown) is formed at stage unit 9 located right below the openings. The groove extends along the openings.

By reducing pressure in the groove of stage unit 9, solar cell main body 20 and tab lead 21 is secured by adsorption to lower belts 4a and 4b via the openings.

At the downstream side of state unit 9 in the transportation direction, a plurality of lower heater blocks 7 are provided to heat solar cell main body 20 and tab lead 21 that are conveyed from below. Lower heat block 7 is covered with a heat insulator 12 except for the side facing lower belts 4a and 4b.

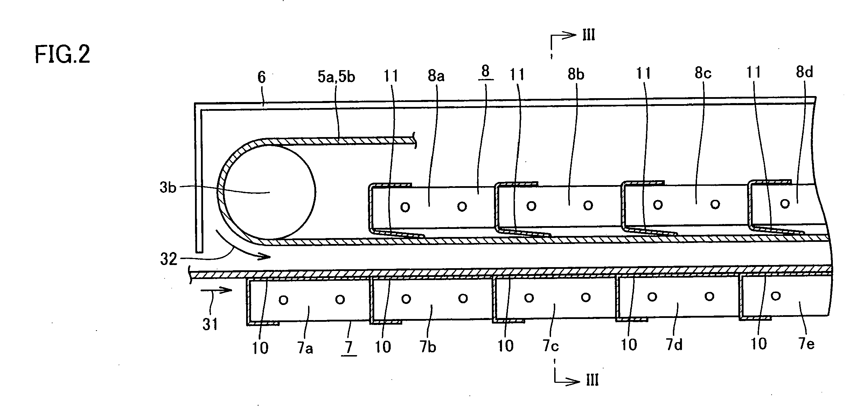

As shown in Fig. 2, a heat conductive plate 10 is provided between lower heater block 7 and lower belts 4a and 4b.

Above lower belts 4a and 4b are provided a pair of upper belts 5a and 5b to press solar cell main body 20 and tab lead 21 towards lower belt 4a and 4b. Upper belts 5a and 5b are formed of, for example, steel.

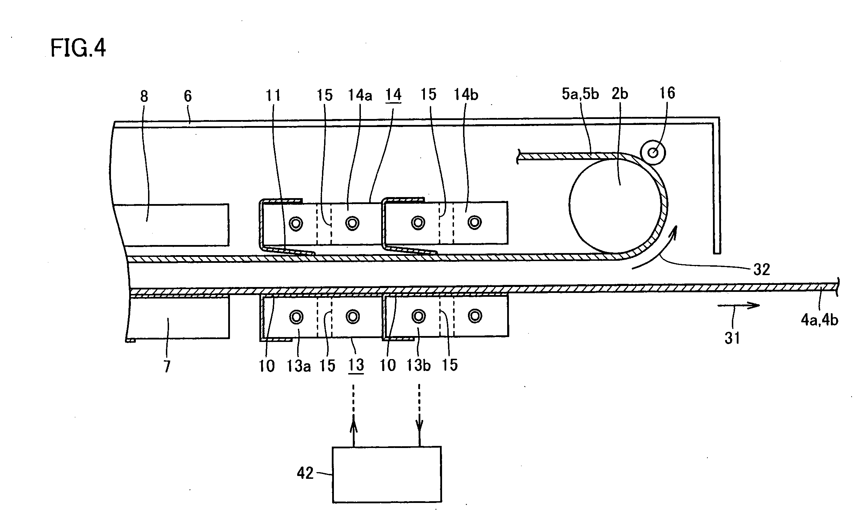

The pair of upper belts 5a and 5b are wound around drive roller 2b (refer to Fig. 4) and a driven roller 3b to be driven in the direction indicated by arrow 32 in synchronization with the motion of lower belts 4a and 4b by drive roller 2b.

The face of upper belts 5a and 5b forming contact with solar cell main body 20 and tab lead 21 is applied with a coating of, for example, Teflon (registered trademark) as a protection film to prevent attachment of flux.

Above upper belts 5a and 5b are provided a plurality of upper heater blocks 8a-8d to heat solar cell main body 20 and tab lead 21 that are conveyed from above. Above upper heater blocks 8a-8d are provided phosphor bronze plates 11 to apply an urging force against upper belts 5a and 5b towards lower belts 4a and 4b.

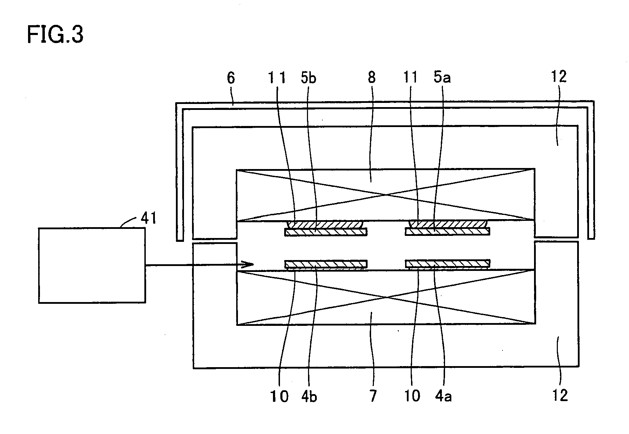

As shown in Fig. 3, upper heater block 8 is covered with heat insulator 12 except for the side that faces upper belts 5a and 5b. Thus, at solar cell fabrication apparatus 1, upper heater blocks 8a-8d and lower heater blocks 7a-7e are surrounded by heat insulator 12 qualified as a furnace along the transportation direction.

In order to suppress formation of an oxide film on the surface of the solder, there is provided an inert gas supply unit 41 to supply inert gas such as nitrogen into the region surrounded by heat insulator 12.

Upper heater block 8, lower belts 5a, 5b, and the like are covered with a predetermined top cover 6, as shown in Fig. 1 and the like.

As shown in Fig. 1, a plurality of lower cooling blocks 13 to cool solar cell main body 20 and tab lead 21 from below are provided at the downstream side of lower heater block 7 in the transportation direction.

As shown in Fig. 4, a heat conductive plate 10 is provided between lower cooling blocks 13a and 13b and lower belts 4a and 4b. Further, above lower belts 4a and 4b are provided a plurality of upper cooling blocks 14a and 14b to cool solar cell main body 20 and tab lead 21 from above, opposite to lower cooling block 13.

Upper cooling blocks 14a and 14b are provided with phosphor bronze plates 11 to apply an urging force against upper belts 5a and 5b towards lower belts 4a and 4b.

Further, a coolant supply unit 42 to supply coolant to is provided.

Additionally, air holes 15 that open towards solar cell 20 and tab lead 21 are formed at upper cooling blocks 14a and 14b and lower cooling blocks 13a and 13b to cool down solar cell 20 and tab lead 21.

A cleaning roller 16 to clean the face of upper belts 5a and 5b forming contact with solar cell main body 20 and tab lead 21 is provided in top cover 6.

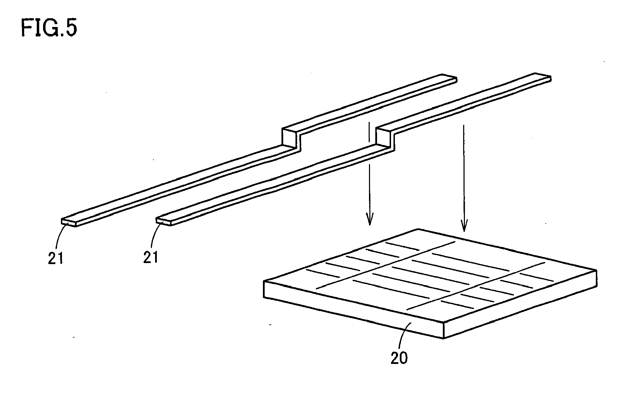

The operation of the solar cell fabrication apparatus set forth above will be described hereinafter. In a positioned state in which tab lead 21 is located at the region where the electrode of solar cell main body 20 is formed, as shown in Fig. 5, solar cell main body 20 and tab lead 21 are sequentially mounted on lower belts 4a and 4b located at stage unit 9.

Solar cell main body 20 and tab lead 21 mounted on lower belts 4a and 4b are secured thereto by adsorption. By the drive of lower belts 4a and 4b, solar cell main body 20 and tab lead 21 are conveyed towards the side where lower heat block 7 and upper heater block 8 are provided in a state maintaining the positioned relationship therebetween.

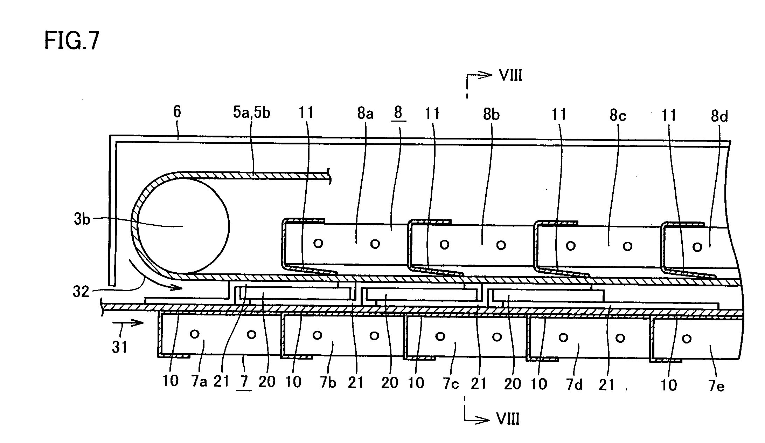

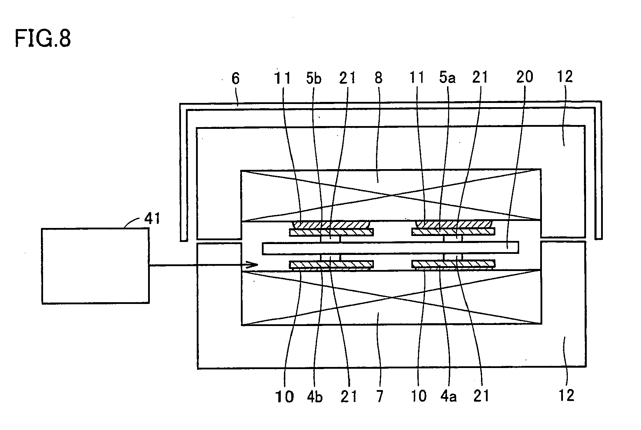

As shown in Figs. 7 and 8, when solar cell main body 20 and tab lead 21 arrive inside upper cover 6, solar cell main body 20 and tab lead 21 are pressed by upper belts 5a and 5b from above in synchronization with the motion of lower belts 4a and 4b. Solar cell main body 20 and tab lead 21 are sandwiched between upper belts 4a and 4b and lower belts 5a and 5b.

Solar cell main body 20 and tab lead 21 located between lower belts 4a and 4b and upper belts 5a and 5b will be conveyed in the sandwiched state. During transportation, solar cell main body 20 and tab lead 21 are heated from below by lower heater blocks 7a-7e, and heated from above by upper heater blocks 8a-8d.

The plurality of lower heater blocks 7a-7e are each set to a predetermined temperature so as to obtain a desired temperature profile suitable for heating and melting solder to connect tab lead 21 to solar cell main body 20 in accordance with the transportation of solar cell main body 20 and tab lead 21.

The plurality of upper heater blocks 8 are each set to a predetermined temperature corresponding to lower heat block 7.

In accordance with the transportation of solar cell main body 20 and tab lead 21, the temperature of solar cell main body 20 and tab lead 21 gradually rises, and the solder applied on tab lead 21 melts when arriving at the zone of the desired temperature.

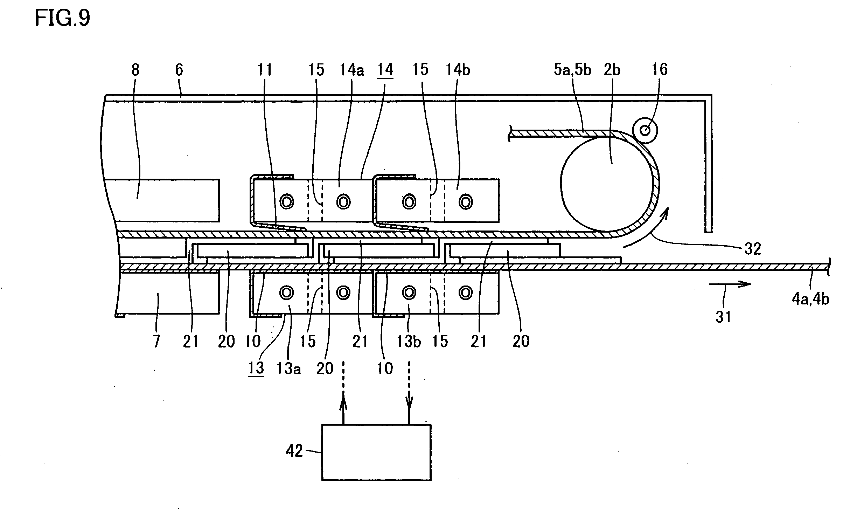

When solar cell main body 20 and tab lead 21 are further conveyed to pass the zone attaining the desired temperature, solar cell main body 20 and tab lead 21 are then gradually cooled by lower cooling block 13 from below and by upper cooling block 14 from above, as shown in Fig. 9.

At the plurality of lower cooling blocks 13, the amount of coolant flowing to lower cooling block 13 by coolant supply unit 42 is adjusted so as to obtain the desired temperature profile suitable for solidification of the melting solder to connect tab lead 21 to solar cell main body 20 according to the transportation of solar cell main body 20 and tab lead 21.

The amount of coolant flowing to upper cooling block 14 is adjusted corresponding to lower cooling block 13, at the plurality of upper cooling blocks 14.

Accordingly, the temperature of solar cell main body 20 and tab lead 21 gradually drops according to the transportation of solar cell main body 20 and tab lead 21. The melting solder is solidified to provide connection between tab lead 21 and solar cell main body 20.

Upon further transportation of solar cell main body 20 and tab lead 21, upper belts 5a and 5b are wound around drive roller 2b such that solar cell main body 20 and tab lead 21 are released from the sandwiched state between lower belts 4a and 4b and upper belts 5a and 5b.

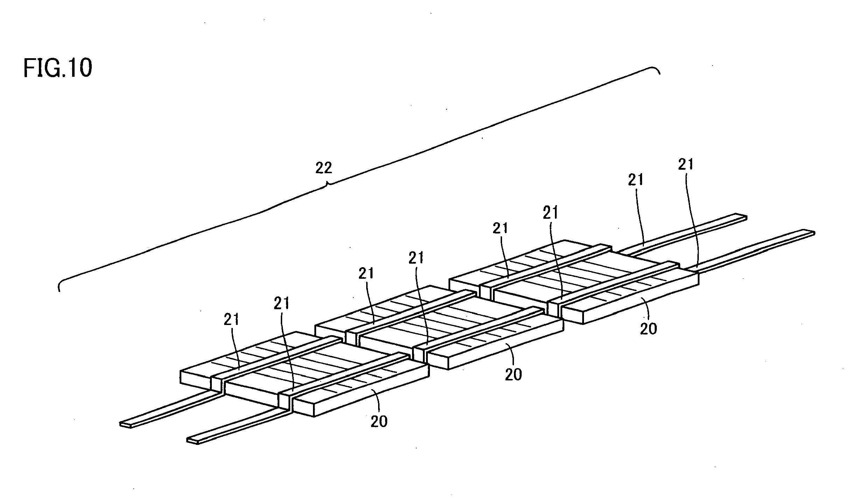

Then, as shown in Fig. 10, solar cell 22 having tab lead 21 soldered to solar cell main body 20 is taken out from lower belts 4a and 4b. Solar cell 22 is delivered to the next step to be sealed between a glass substrate and a back film by predetermined resin.

According to the solar cell fabrication apparatus set forth above, the entirety of solar cell main body 20 and tab lead 21 will be pressed appropriately by the weight of upper belts 5a and 5b and the elasticity of phosphor bronze plate 11.

Accordingly, generation of distortion at solar cell main body 20 can be suppressed since solar cell main body 120 will no longer be pressed locally by tab lead 121 as in a conventional solar cell fabrication apparatus 101. Thus, the yield of solar cell 22 can be improved.

The elasticity of phosphor bronze plate 11 qualified as an elastic member can be altered according to the configuration of the solar cell and tab lead to be fabricated. Therefore, the solar cell and tab lead can be pressed more appropriately to ensure that generation of strain at solar cell main body 20 is suppressed.

As compared to the case where tab lead 121 is pressed locally against solar cell main body 120 by pressing rod 112 as in a conventional solar cell fabrication apparatus 101, the entirety of tab lead 21 is pressed by upper belts 5a and 5b. Therefore, the surface of the solder is flat all over tab lead 21 without any generation of a protruding solder.

In the step where solar cell 22 is sealed by predetermined resin between a glass substrate and back film, the problem of the solar cell main body being damaged by the contact of the tip of the protruding solder with the glass substrate can be prevented. Thus, the yield of the solar cell can be improved.

Further, reduction in the life time of the solar cell is also prevented since entry of oxygen caused by the protruding solder penetrating the resin to form contact with the glass substrate is prevented. Therefore, the quality of the solar cell can be maintained.

Conventional solar cell fabrication apparatus 101 is disadvantageous in that, when the size of the solar cell main body is to be altered, the interval of pressing rods 112 attached to endless belt 111 has to be modified in accordance with the size of the solar cell main body.

In contrast, solar cell fabrication apparatus 1 does not require this labor when the size of the solar cell main body is to be altered since the entirety of solar cell main body 20 and tab lid 21 is pressed by upper belts 5a and 5b.

Further, the provision of phosphor bronze plate 11 between upper belts 5a and 5b and upper heater block 8 prevents abrasion of upper heater block 8 in association with the drive of upper belts 5a and 5b.

Similarly, the provision of heat conductive plate 10 between lower belts 4a and 4b and lower heater block 7 prevents abrasion of lower heater block 7 in association with the drive of lower belts 4a and 4b.

The face of upper belts 5a and 5b that is brought into contact with solar cell main body 20 and tab lead 21 has a protection film such as Teflon (registered trademark) formed to prevent flux attachment.

Accordingly, damage and the like of solar cell main body 20 due to the accumulation of flux at the surface of upper belts 5a and 5b to cause solder attachment is prevented. As a result, the yield of the solar cell can be improved.

Further, flux can be removed, even if it is attached to the surface of upper belts 5a and 5b, at a relatively initial stage by cleaning roller 16. Therefore, gradual accumulation of flux can be prevented, and the maintenance property can be improved.

Solar cell fabrication apparatus 1 has upper and lower heater blocks 8 and 7 surrounded by a heat insulator 12 qualified as a furnace along the transportation direction. Solar cell main body 20 and tab lead 21 are conveyed between upper heater blocks 8a-8d and lower heater blocks 7a-7e.

As compared to conventional solar cell fabrication apparatus 101 having the region where tab lead is located locally heated by the lamp heater, the entirety of solar cell main body 20 is heated at solar cell fabrication apparatus 1. Therefore, generation of heat strain at solar cell main body 20 can be reduced. As a result, the yield of the solar cell can be improved.

Further, with regards to upper heater block 8 and lower heater block 7, a plurality of upper heater blocks 8a-8d and lower heater blocks 7a-7e are provided.

By adjusting the setting temperature of each of upper heater blocks 8a-8d and lower heater blocks 7a-7e, the desired temperature profile suitable for heating and melting the solder for connection between tab lead 21 and solar cell main body 20 can be obtained.

As a result, generation of heat strain at solar cell main body 20 can be reduced to improve the yield of the solar cell.

Further, the provision of upper and lower heater blocks 8 and 7 at the inner side of heat insulator 12 qualified as a furnace suppresses the escape of heat radiation to ensure a relatively high thermal efficiency. This leads to a saving of power consumption, contributing to saving energy.

Further, introduction of inert gas into the region surrounded by heat insulator 12 allows this region to be maintained in inert gas atmosphere. Therefore, formation of an oxide film on the surface of solder is suppressed and solder wettability is improved. As a result, tab lead 21 can be reliably connected to solar cell main body 20.

With regards to upper cooling block 14 and lower cooling block 13 at solar cell fabrication apparatus 1, a plurality of upper cooling blocks 14a and 14b and lower cooling blocks 13a and 13b, respectively, are provided. Coolant is supplied by coolant supply unit 42 to upper cooling blocks 14a and 14b and lower cooling blocks 13a and 13b.

By adjusting the amount of coolant flowing to each of upper cooling blocks 14a and 14b and lower cooling blocks 13a and 13b, the desired temperature profile suitable for solidification of the melting solder for connection between tab lead 21 and solar cell main body 20 can be obtained.

As a result, distortion in association with cooling solar cell main body 20 is reduced, and the yield of the solar cell can be improved.

The temperature adjustment (control) of each of upper cooling blocks 14a and 14b and lower cooling blocks 13a and 13b can be conducted relatively easily by adjusting the amount of coolant.

By delivering air to air hole 15 provided at each of upper cooling blocks 14a and 14e and lower cooling blocks 13a and 13b, the air cooled by heat exchange can be blown towards solar cell main body 20 and tab lead 21. As a result, solar cell main body 20 and tab lead 21 can be cooled efficiently.

By virtue of solar cell fabrication apparatus 1, the generation of distortion and the possibility of damage at solar cell main body 20, readily occurring at a conventional solar cell fabrication apparatus, are significantly suppressed. As a result, the yield of solar cell main body 20 can be improved, which in turn allows improvement of the quality of solar cell main body 20. Further, power consumption is reduced, contributing to saving energy.

In the solar cell fabrication apparatus set forth above, phosphor bronze plate 11 was taken as an example for an elastic member applying urging force against upper belts 5a and 5b towards lower belts 4a and 4b.

The resilient member is not limited to a phosphor bronze plate. Any of a material that can apply the urging force set forth above and prevent abrasion of upper heater block 8 with respect to the movement of upper belts 5a and 5b may be used.

Further, a Teflon (registered trademark) coating was taken as an example of a protection film formed on the plane of upper belts 5a and 5b that is to be brought into contact with solar cell main body 20 and tab lead 21.

The protection film is not limited to Teflon (registered trademark) coating, and any that can prevent flux attachment may be employed.

It should be understood that the embodiments disclosed herein are illustrated and non-restricted in every respect. The scope of the present invention is defined by the terms of the claims, rather than the description above, and is intended to include any modification within the scope and meaning equivalent to the terms of the claims.

### Industrial Applicability

The present invention is effectively applicable to soldering a tab lead to a solar cell main body.

## Claims

1. A solar cell fabrication apparatus to solder a tab lead (21) to a solar cell main body (20), comprising:
a conveyor unit (2a, 3 a, 4a, 4b) carrying a solar cell main body (20) and a tab lead (21) to convey the solar cell main body (20) and tab lead (21) in one direction,
a lower heating unit (7) provided below said conveyor unit (2a, 3a, 4a, 4b) to heat a solar cell main body (20) and tab lead (21) from below,
an upper heating unit (8) provided above said conveyor unit (2a, 3a, 4a, 4b), opposite to said lower heating unit (7), to heat a solar cell main body (20) and tab lead (21) from above, and
a furnace unit (12) arranged to surround said conveyor unit (2a, 3a, 4a, 4b), said lower heating unit (7) and said upper heating unit (8) along in one direction.

2. The solar cell fabrication apparatus according to claim 1, wherein a plurality of each of said lower heating unit (7) and said upper heating unit (8) are provided along in one direction.

3. The solar cell fabrication apparatus according to claim 1, comprising an inert gas supply unit (41) to supply inert gas into said furnace unit (12).

4. A solar cell fabrication apparatus to solder a tab lead (21) to a solar cell main body (20), comprising:
a conveyor unit (2a, 3 a, 4a, 4b) carrying a solar cell main body (20) and a tab lead (21) to convey the solar cell main body (20) and tab lead (21) in one direction,
a lower heating unit (7) provided below said conveyor unit (2a, 3a, 4a, 4b) to heat a solar cell main body (20) and tab lead (21) from below,
a belt unit (5a, 5b) provided above said conveyor unit (2a, 3a, 4a, 4b), pressing the solar cell main body (20) and the tab lead (21) arranged at a predetermined position with respect to the solar cell main body (20) towards said conveyor unit (2a, 3 a, 4a, 4b) in synchronization with a motion of said conveyor unit (2a, 3 a, 4a, 4b),
an elastic member (11) provided above said belt unit (5a, 5b) to apply an urging force against said belt unit (5a, 5b) towards said conveyor unit (2a, 3a, 4a, 4b), and
an upper heating unit (8) provided above said conveyor unit (2a, 3a, 4a, 4b), opposite to said lower heating unit (7), to heat a solar cell main body (20) and tab lead (21) from above.

5. The solar cell fabrication apparatus according to claim 4, wherein said elastic member (11) is arranged between said belt unit (5a, 5b) and said upper heating unit (8).

6. The solar cell fabrication apparatus according to claim 4, wherein a heat conductive plate (10) is arranged between said conveyor unit (2a, 3a, 4a, 4b) and said lower heating unit (7).

7. The solar cell fabrication apparatus according to claim 4, wherein a predetermined protection film for preventing flux attachment is formed on a face of said belt unit (5a, 5b) at a side forming contact with a solar cell main body (20) and tab lead (21).

8. The solar cell fabrication apparatus according to claim 4, comprising a cleaning mechanism (16) to clean a face of said belt unit (5a, 5b) at a side forming contact with a solar cell main body (20) and tab lead (21).

9. A solar cell fabrication apparatus to solder a tab lead (21) to a solar cell main body (20), comprising:
a conveyor unit (2a, 3 a, 4a, 4b) carrying a solar cell main body (20) and a tab lead (21) to convey the solar cell main body (20) and tab lead (21) in one direction,
a heating unit (7, 8) heating a solar cell main body (20) and tab lead (21) conveyed by said conveyor unit (2a, 3 a, 4a, 4b),
a plurality of lower cooling units (13) provided below said conveyor unit (2a, 3a, 4a, 4b) to cool a solar cell main body (20) and tab lead (21) heated by said heating unit (7, 8) from below, and
a plurality of upper cooling units (14) provided above said conveyor unit (2a, 3a, 4a, 4b), opposite to said lower cooling unit (13), to cool a solar cell main body (20) and tab lead (21) from above.

10. The solar cell fabrication apparatus according to claim 9, comprising a coolant supply unit (42) to supply coolant to each of said lower cooling unit (13) and said upper cooling unit (14).
